(19) Europäisches Patentamt
European Patent Office
Office européen des brevets

(11) EP 2 858 108 A2

(12) EUROPEAN PATENT APPLICATION

(43) Date of publication:
08.04.2015 Bulletin 2015/15

(51) Int Cl.:
H01L 23/473 (2006.01)          H01L 23/40 (2006.01)

(21) Application number: 14185326.7

(22) Date of filing: 18.09.2014

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 02.10.2013  JP 2013207602

(71) Applicant: FUJITSU LIMITED
Kawasaki-shi,
Kanagawa 211-8588 (JP)

(72) Inventors:
• So, Tsuyoshi
Kanagawa, 211-8588 (JP)
• Hirai, Keita
Kanagawa, 211-8588 (JP)
• Uzuka, Yoshinori
Kanagawa, 211-8588 (JP)

(74) Representative: Hoffmann Eitle
Patent- und Rechtsanwälte PartmbB
Arabellastraße 30
81925 München (DE)

(54) **Cooling device, electronic apparatus and method of attaching cooling device**

(57)    A cooling device includes a cooling member connected with a cooling pipe through which a cooling medium flows, a first fastening mechanism part provided at a first position on the cooling member and configured to fasten the cooling member and a substrate in a state where an electronic part to be cooled is sandwiched between the cooling member and the substrate, and a second fastening mechanism part provided at a second position on the cooling member that is different from the first position, the second position being located at a position where a first load exerted on the cooling member and a second load exerted on the cooling member maintain a balance in the electronic part, the first load being applied by the cooling pipe and the first fastening mechanism part, the second load being applied by the second fastening mechanism part.

FIG. 2

**Description**

FIELD

The embodiments discussed herein are related to a cooling device, an electronic apparatus, and a method of attaching the cooling device.

BACKGROUND

Recently, an electronic apparatus is being improved to have high performance. With the high performance of the electronic apparatus, there have been developed various cooling devices to cool electronic parts that generate heat (See, e.g., Japanese Laid-Open Patent Publication No. 2004-356385).

When a cooling member circulating a cooling medium such as liquid or gas is attached to an electronic part, a load is applied from a cooling pipe connected to the cooling member to the electronic part. Thus, when the cooling member is fastened to a substrate in a state where the electronic part to be cooled is sandwiched between the cooling member and the substrate, a load is applied to the electronic part from the cooling pipe in addition to the load from a fastening mechanism that fastens the cooling member to the substrate. Accordingly, when it is designed such that the load from the fastening mechanism is evenly applied to the electronic part, the load applied to the electronic part becomes unbalanced when a load is further applied from the cooling pipe. The unbalanced load applied to the electronic part leads to, for instance, a reduction in cooling performance due to the deformation of the cooling member, or to a failure of the electronic part due to the load concentrated on a specific location.

Accordingly, an object of the present disclosure is to provide a cooling device, an electronic apparatus, and a method of attaching the cooling device, which are intended to decrease a load applied to an electronic part from being unbalanced.

SUMMARY

According to an aspect of the invention, a cooling device includes a cooling member connected with a cooling pipe through which a cooling medium flows, a first fastening mechanism part provided at a first position on the cooling member and configured to fasten the cooling member and a substrate in a state where an electronic part to be cooled is sandwiched between the cooling member and the substrate, and a second fastening mechanism part provided at a second position on the cooling member that is different from the first position, the second position being located at a position where a first load exerted on the cooling member and a second load exerted on the cooling member maintain a balance in the electronic part, the first load being applied by the cooling pipe and the first fastening mechanism part, the second load being applied by the second fastening mechanism part.

BRIEF DESCRIPTION OF DRAWINGS

FIG. 1 is a view illustrating the configuration of an electronic apparatus to which a cooling device according to an exemplary embodiment of the present disclosure is fastened;
FIG. 2 is a view illustrating a connected position of each fastening mechanism and a cooling pipe;
FIG. 3 is a view illustrating a cooling device according to a modified embodiment;
FIG. 4 is a view illustrating a state where a plurality of cooling devices is arranged according to the modified embodiment;
FIG. 5 is a view illustrating a modified embodiment of the cooling pipe connected to the cooling device; and
FIG. 6 is a view illustrating a connected position of each fastening mechanism or cooling pipe of a conventional cooling device.

DESCRIPTION OF EMBODIMENTS

Hereinafter, exemplary embodiments of the present disclosure will be described. A cooling device, an electronic apparatus, and a method of attaching a cooling device as described in embodiments are intended to suppress load applied to an electronic part from being unbalanced.

The exemplary embodiments are for illustrative purposes only and are not intended to limit the technical scope of the present disclosure.

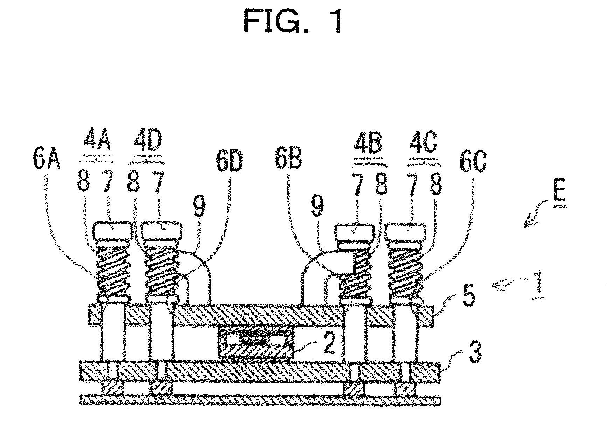

FIG. 1 is a view illustrating the configuration of an electronic apparatus E to which a cooling device 1 is fastened according to an exemplary embodiment of the present disclosure. For example, as illustrated in FIG. 1, a cooling device 1 fastened to an electronic apparatus E is secured to a substrate 3 in a state where an electronic part 2 to be cooled is fitted into the cooling device 1. Each of fastening mechanisms 4A, 4B, 4C and 4D for fastening the cooling device 1 to the substrate 3 includes a fastening screw 7 (*e.g.,* a fastening member according to the present disclosure) that is inserted into each of through holes 6A, 6B, 6C and 6D formed in a cooling member 5 of the cooling device 1, and a compression spring 8 (*e.g.,* an elastic member according to the present disclosure) into which the fastening screw 7 is inserted. An internal diameter of each through hole 6A, 6B, 6C and 6D is larger than an external diameter of the fastening screw 7. Thus, since the cooling member 5 is movable in a longitudinal direction of the fastening screw 7 but is biased by the compression spring 8, the cooling member 5 is secured to the substrate 3 in a state where the electronic part 2 is sandwiched between the cooling member 5 and the substrate 3. The compression springs 8 included in each of the fastening mechanisms 4A, 4B, 4C and 4D are equivalent parts and thus the compression springs 8 apply almost equal load to press the cooling member 5. Hence, all the load of the respective fastening mechanisms 4A, 4B, 4C and 4D for pressing the cooling member 5 will be referred to as F1.

The cooling member 5 is connected with a cooling pipe 9 to circulate coolant therethrough. Thus, load is transmitted from the cooling pipe 9 to the electronic part 2 through the cooling member 5. Hereinafter, the load applied from the cooling pipe 9 to the cooling member 5 will be referred to as F2. The cooling pipe 9 is connected to, for example, a pump or cooler (not illustrated), or is supported by various support members. Thus, the magnitude of F2 depends on an attached state of the cooling member 5 or the cooling pipe 9, but it is possible to maintain the magnitude of F2 within a predetermined range according to the design of the cooling member 5 or cooling pipe 9.

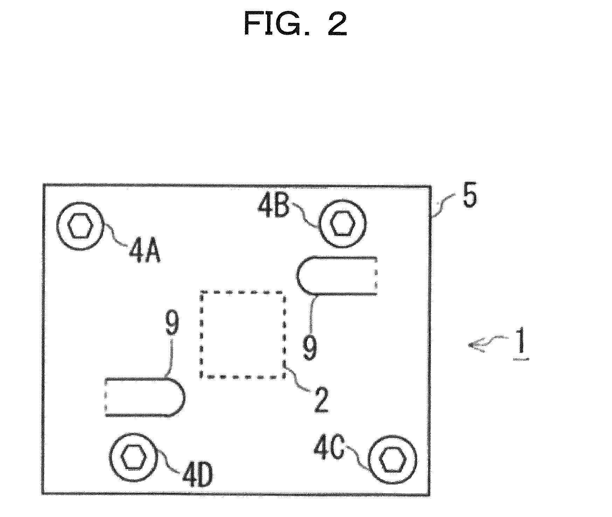

FIG. 2 is a view illustrating a connected position of each fastening mechanism or the cooling pipe. The fastening mechanisms 4A, 4B, 4C and 4D and the cooling pipe 9 are located at positions as illustrated in FIG. 2. That is, the fastening mechanisms 4A and 4C are located at two facing corners on the cooling member 5 which is a rectangular plate member. In contrast, the fastening mechanisms 4B and 4D applying almost identical load to the fastening mechanisms 4A and 4C to the cooling member 5 are not located at corners of the cooling member 5 unlike the fastening mechanisms 4A and 4C, but are located at predetermined positions on two facing sides of the cooling member 5, respectively. Further, the fastening mechanism 4A, 4B, 4C, and 4D are located so that lines connecting the fastening mechanisms 4A, 4B, 4C and 4D form a parallelogram.

The positions of the fastening mechanisms 4A, 4B, 4C and 4D for attaching the cooling device 1 to the substrate 3 are determined by the following method. That is, first, the through holes 6A and 6C (*e.g.,* a first fastening mechanism part as described herein) for disposing the fastening mechanisms 4A and 4C are formed at predetermined positions on the cooling member 5. Further, the through holes 6B and 6D (*e.g.,* a second fastening mechanism part as described herein) for disposing the fastening mechanisms 4B and 4D are formed at a position on the cooling member 5 in which load (*e.g.,* the first load described herein) applied to the cooling member 5 by the cooling pipe 9 and the fastening mechanisms 4A and 4C and load (*e.g.,* the second load described herein) applied to the cooling member 5 by the fastening mechanisms 4B and 4D are balanced in the electronic part 2.

For example, the position where the loads are balanced may be calculated by the following method. It is assumed that the distance from the through hole 6A to the electronic part 2 is L1, the distance from the through hole 6B to the electronic part 2 is L2, and the distance from a connected portion of the cooling pipe 9 to the electronic part 2 is L3. In this case, the pressurizing moment by which the load F1 of the fastening mechanism 4A affects the electronic part 2 corresponds to F1×L1. Further, the pressurizing moment by which the load F2 of the cooling pipe 9 affects the electronic part 2 corresponds to F2xL3. Thus, when the load of the fastening mechanism 4B is established as F1 that is identical with the load of the fastening mechanism 4A, and the load of the fastening mechanism 4A and the load of the fastening mechanism 4B are balanced in the electronic part 2, the following equation is satisfied.

$$F1 \times L1 = F1 \times L2 + F2 \times L3$$

The position at which the through hole 6B for disposing the fastening mechanism 4B should be formed to be spaced apart from the electronic part 2 by the distance L2 may be determined based on the above equation. The position of the through hole 6D is also determined in the same manner as the through hole 6B.

When the cooling device 1 is determined as described above, the load applied to the cooling member 5 by the cooling pipe 9 and the fastening mechanisms 4A and 4C balances out with the load applied to the cooling member 5 by the fastening mechanisms 4B and 4D at the position of the electronic part 2. Thus, because the cooling pipe 9 is connected to the cooling member 5 to which almost identical load is transmitted from any one of the fastening mechanisms 4A, 4B, 4C and 4D, the load transmitted from the cooling member 5 to the electronic part 2 is suppressed from being unbalanced. Consequently, this may reduce the possibility that cooling performance is deteriorated due to the deformation of the cooling member 5 or load concentrated on a specific position causes the failure of the electronic part 2. When the load applied to the electronic part 2 is suppressed from being unbalanced, this enables load to be more evenly applied to a plurality of solder bumps connecting the electronic part 2 with the substrate 3, thereby improving the reliability of an electrically connected portion.

The cooling device 1 is not limited to the above-mentioned embodiment. For example, the cooling member 5 may have a square shape instead of the rectangular shape. Further, the cooling device 1 may be modified as follows.

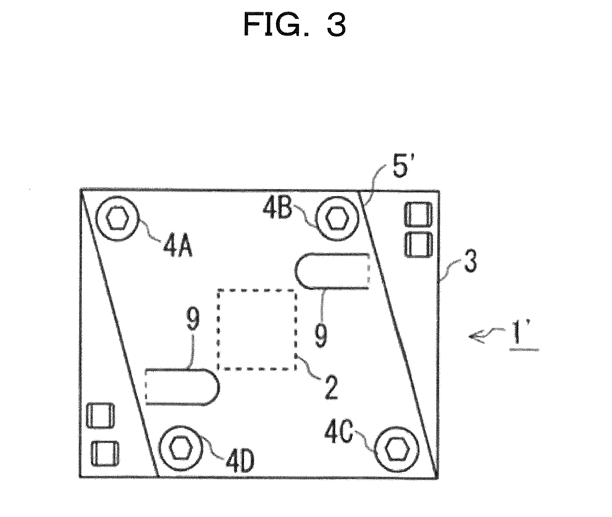

FIG. 3 is a view illustrating a cooling device according to a modified embodiment. In the cooling device 1' according to the modified embodiment, a cooling member 5' is not a rectangular plate member but is a parallelogram plate member. Further, the fastening mechanisms 4A and 4C are provided on acute-angled edges of the cooling member 5', while fastening mechanisms 4B and 4D are provided on obtuse-angled edges of the cooling member 5'.

Since the cooling member 5' of the cooling device 1' according to the modified embodiment is smaller than the cooling member 5 according to the exemplary embodiment, it is possible to increase the space of the substrate 3 for mounting the electronic part.

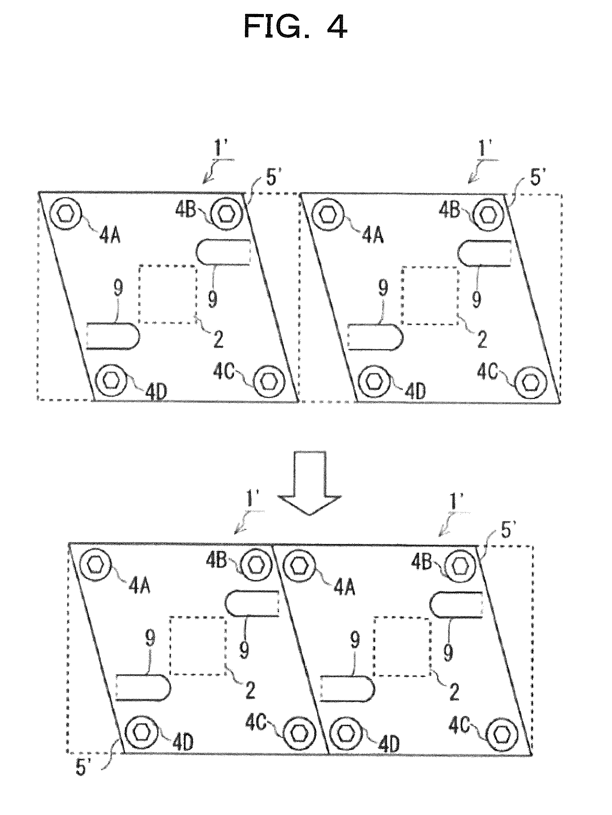

FIG. 4 is a view illustrating a state where a plurality of cooling devices 1' is arranged according to the modified embodiment. Since the cooling member 5' of the cooling device 1' according to the modified embodiment is smaller than the cooling member 5 according to the exemplary embodiment, the cooling devices 1' may be arranged close to each other to increase a mounting density. This arrangement may reduce a space occupied by all of the cooling devices 1'.

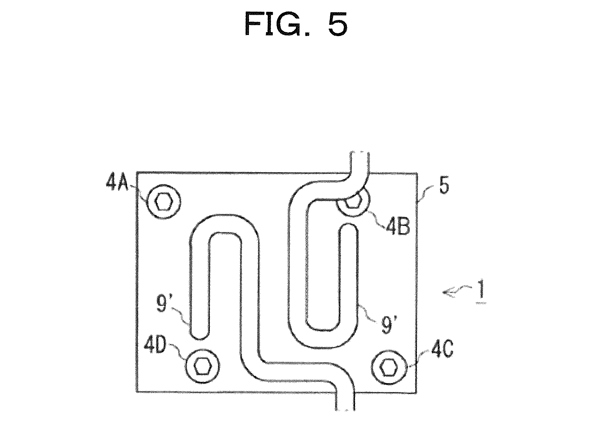

FIG. 5 is a view illustrating a modified embodiment of the cooling pipe connected to the cooling device 1. The cooling pipe of the cooling device 1 may have the shape of a cooling pipe 9' as illustrated in FIG. 5. The cooling pipe 9' according to the present modified embodiment is intended to maintain the magnitude of the load F2 within a predetermined range, and is formed to extend around a connected portion to the cooling member 5. Since the cooling pipe 9' extending around the connected portion is liable to be elastically deformed, it is difficult for the magnitude of F2 to be affected by the attached state of the cooling member 5 or the cooling pipe 9'. Therefore, it is easy to maintain the magnitude of F2 within a predetermined range. When the magnitude range of F2 becomes narrow, it is possible to calculate the positional relationship between the respective through holes 6A, 6B, 6C and 6D, which are determined based on the above equation, thus further suppressing the unbalancing of the load applied to the electronic part 2.

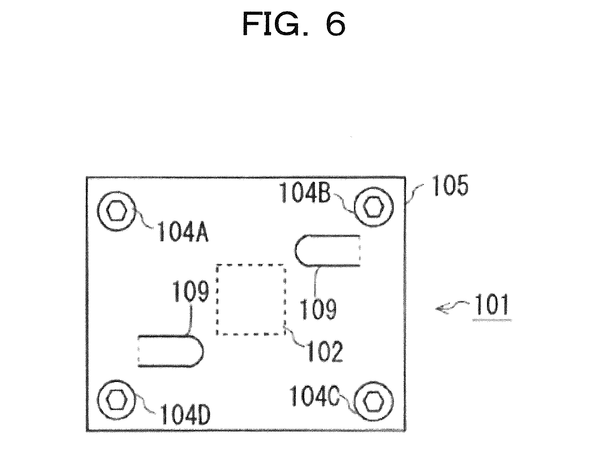

FIG. 6 is a view illustrating a connected position of each fastening mechanism or cooling pipe of a conventional cooling device. In the conventional cooling device 101, fastening mechanisms 104A, 104B, 104C and 104D and a cooling pipe 109 are arranged at positions as illustrated in FIG. 6. That is, all of the fastening mechanisms 104A, 104B, 104C and 104D are disposed, respectively, on four corners of a cooling member 105 which is a rectangular plate member.

Hereinafter, the load of each fastening mechanism 104A, 104B, 104C or 104D biasing the cooling member 105 will be referred to as F1', and the load applied from the cooling pipe 109 to the cooling member 105 will be referred to as F2'. Further, the distance from each fastening mechanism 104A, 104B, 104C or 104D to the electronic part 102 will be referred to as L1', and the distance from the connected portion of the cooling pipe 109 to the electronic part 102 will be referred to as L2'. In this case, the pressurizing moment acting on the electronic part 102 by the fastening mechanisms 104A and 104C corresponds to F1'×L1'. The pressurizing moment acting on the electronic part 102 by the fastening mechanisms 104B and 104D corresponds to F1'×L1'+F2'×L2'. That is, in the case of the conventional cooling device 101, pressurizing moment is generated twisting the electronic part 102 or the cooling member 105.

As various electronic apparatuses, such as a server, are developed to have high performance, the mounting density or heating value of the electronic part is increasing every year. For this reason, the dimension or weight of the cooling device also tends to increase. For instance, when the weight of the cooling device increases, vibration or shocks exerts a strong influence during the transportation of the electronic apparatus and thereby load acting on parts for supporting various parts constituting the cooling device increases likewise. For example, the load required to pressurize a thermal interface material (TIM) which is used between the electronic part and the cooling member increases in order to satisfy the cooling performance.

Even though the load for each part of the cooling device increases, when the load is evenly applied to the electronic part to be cooled, it is possible to suppress the cooling part or the electronic part from being damaged to a desired level. However, when the load is distributed unbalanced, the load is concentrated on a specific portion of the cooling part or electronic part, thus causing the damage to parts or generating a gap and thereby deteriorating the cooling performance. Further, when the load is concentrated on the solder bump for the electric connection of the electronic part, it leads to the destruction of the solder bump, thus undesirably reducing the reliability of the electronic apparatus. Thus, when the conventional cooling device 101 is used, the pressurizing moment of twisting the electronic part 102 or the cooling member 105 is generated, so that it is difficult to restrain the effect of vibration or shocks during the transportation of the electronic apparatus.

However, the cooling device according to the above-mentioned embodiment or modification suppresses the load exerted on the electronic part from becoming unbalanced. Therefore, the present disclosure can reduce the possibility that the cooling performance is deteriorated due to the deformation of the cooling member or the load concentrating on a specific position causes the failure of the electronic part.

**Claims**

1. A cooling device, comprising:

   a cooling member connected with a cooling pipe through which a cooling medium flows;
   a first fastening mechanism part provided at a first position on the cooling member and configured to fasten the cooling member and a substrate in a state where an electronic part to be cooled is sandwiched between the cooling member and the substrate; and
   a second fastening mechanism part provided at a second position on the cooling member that is different from the first position, the second position being located at a position where a first load exerted on the cooling member and a second load exerted on the cooling member maintain a balance in the electronic part, the first load being applied by the cooling pipe and the first fastening mechanism part, the second load being applied by the second fastening mechanism part.

2. The cooling device according to claim 1, wherein the cooling member is a parallelogram-shaped plate member,
the first fastening mechanism part is provided on either one of an acute-angled edge and an obtuse-angled edge of the cooling member, and
the second fastening mechanism part is provided on the remainder of the acute-angled edge and the obtuse-angled edge of the cooling member.

3. The cooling device according to claim 1 or 2, wherein the second fastening mechanism part is provided at a position where the first load and the second load maintain a balance in the electronic part, when load exerted on the cooling member by the first fastening mechanism part is established to be identical to load exerted on the cooling member by the second fastening mechanism part.

4. The cooling device according to any one of claims 1 to 3, wherein each of the first and second fastening mechanism parts includes a hole for inserting a fastening member that fastens an elastic member pressing the cooling member towards the electronic part to the substrate.

5. The cooling device according to any one of claims 1 to 4, wherein the cooling pipe is formed to extend around a connected portion to the cooling member.

6. An electronic apparatus including the cooling device according to any one of claims 1 to 5, wherein the electronic part is provided on the substrate.

7. The electronic apparatus according to claim 6, wherein each of the first and second fastening mechanism parts includes:

   an elastic member configured to press the cooling member towards the electronic part; and
   a fastening member configured to fasten the elastic member to the substrate.

8. A method of attaching a cooling device, comprising:

   providing a first fastening mechanism part at a first position on a cooling member connected with a cooling pipe through which a cooling medium flows, the first fastening mechanism part fastening the cooling member and a substrate in a state where an electronic part to be cooled is sandwiched between the cooling member and the substrate; and
providing a second fastening mechanism part at a second position on the cooling member that is different from the first position, the second position being located at a position where a first load exerted on the cooling member and a second load exerted on the cooling member maintain a balance in the electronic part, the first load being applied by the cooling pipe and the first fastening mechanism part, the second load being applied by the second fastening mechanism part.

9. The method according to claim 8, wherein the cooling member is a parallelogram-shaped plate member,
the first fastening mechanism part is provided on either one of an acute-angled edge and an obtuse-angled edge of the cooling member, and
the second fastening mechanism part is provided on the remainder of the acute-angled edge and the obtuse-angled edge of the cooling member.

10. The method according to claim 8 or 9, wherein the second fastening mechanism part is provided at a position where the first load and the second load maintain a balance in the electronic part, when load exerted on the cooling member by the first fastening mechanism part is established to be identical to load exerted on the cooling member by the second fastening mechanism part.

11. The method according to any one of claims 8 to 10, wherein each of the first and second fastening mechanism parts includes a hole for inserting a fastening member that fastens an elastic member biasing the cooling member towards the electronic part to the substrate.

12. The method according to any one of claims 8 to 11, wherein the cooling pipe is formed to extend around a connected portion to the cooling member.

FIG. 1

# FIG. 2

# FIG. 3

# FIG. 4

# FIG. 5

# FIG. 6

**REFERENCES CITED IN THE DESCRIPTION**

**Patent documents cited in the description**

- JP 2004356385 A